# FASCICULE DE BREVET EUROPEEN

(11) **EP 2 788 999 B1**
(45) Date de publication et mention de la délivrance du brevet: **09.12.2015**
(21) Numéro de dépôt: 12799181.8
(22) Date de dépôt: 10.12.2012
(51) Int. Cl.: H03K 17/90, H01H 19/14, H01H 19/60, H01H 19/11, H01H 19/00

(54) **DISPOSITIF DE COMMANDE ELECTRIQUE ROTATIF**
ROTIERENDE ELEKTRISCHE STEUERUNGSVORRICHTUNG
ROTARY ELECTRICAL CONTROL DEVICE

(30) Priorité: 09.12.2011 FR 1161374
(43) Date de publication de la demande: 15.10.2014
(73) Titulaire: Apem, 82300 Caussade (FR)
(72) Inventeur: MORA, Cédric, 82130 L'Honor de Cos (FR)
(74) Mandataire: Regimbeau
(86) Numéro de dépôt international: PCT/EP2012/074963
(87) Numéro de publication internationale: WO 2013/083841

(56) Documents cités:
- DE-A1- 10 234 512
- DE-U1-202007 015 194
- DE-U1-202008 013 517
- US-A- 4 154 991
- US-A1- 2010 328 094

## Description

### DOMAINE DE L'INVENTION

La présente invention concerne un dispositif de commande électrique rotatif.

### ARRIERE PLAN DE L'INVENTION

Les dispositifs de commande électrique rotatifs trouvent de diverses applications, par exemple sur des tableaux de bord, des télécommandes, des dispositifs manipulateurs, etc.

Le fonctionnement de ces dispositifs est basé sur la rotation d'un actionneur par rapport à un corps fixe, l'angle de déplacement de l'actionneur se traduisant par la génération d'un signal électrique déterminé.

A cet effet, le dispositif comprend un capteur porté par un circuit imprimé fixe par rapport au corps et l'actionneur comprend un élément détectable par un capteur.

La technologie basée sur l'effet Hall est ainsi largement employée pour fabriquer de tels dispositifs rotatifs : le capteur fixe est un capteur à effet Hall et l'élément détectable est un aimant solidaire de l'actionneur, le déplacement de l'aimant induisant une variation de champ magnétique qui est mesurée par le capteur et exploitée sous la forme d'un signal de sortie fonction de l'amplitude ou course angulaire du déplacement.

Ainsi, le document US 2011/00325058 décrit un commutateur rotatif employant la technologie effet Hall.

Ce commutateur comprend un corps qui supporte un capteur à effet Hall ainsi qu'une série de diodes électroluminescentes de différentes couleurs.

Le corps porte aussi un axe pour la rotation d'un actionneur qui est solidaire de deux aimants.

Un ressort de torsion permet de rappeler l'actionneur vers une position neutre.

En fonction de l'amplitude de la rotation de l'actionneur, qui est mesurée par le capteur à effet Hall, une diode électroluminescente d'une couleur déterminée s'allume pour indiquer à l'utilisateur l'état de commutation du commutateur.

Cependant, le débattement angulaire de l'actionneur est limité par la présence de pattes de fixation qui s'étendent radialement de part et d'autre du corps et par des limiteurs d'angle agencés sur l'actionneur lui-même.

Cette conception ne peut donc être retenue pour fabriquer un dispositif dont l'amplitude de rotation de l'actionneur serait plus importante, notamment de 360°.

Par ailleurs, cette conception ne permet de monter le dispositif qu'en position dite verticale, c'est-à-dire une position dans laquelle l'axe de rotation de l'actionneur est parallèle à la surface du support (tableau de bord, télécommande, etc.) sur lequel le dispositif est monté, l'actionneur tournant dans un plan perpendiculaire à la surface dudit support.

Or, dans certaines applications, on préfère monter le dispositif en position dite horizontale, c'est-à-dire dans laquelle l'axe de rotation de l'actionneur est perpendiculaire à la surface du support sur lequel le dispositif est monté, l'actionneur tournant alors dans un plan parallèle à la surface dudit support.

Par ailleurs, selon les applications, il peut être nécessaire de prévoir plusieurs positions de commutation, par exemple réparties régulièrement sur 360°, d'indexer angulairement lesdites positions, etc.

DE-U1-202008013517 décrit un dispositif de commande électrique rotatif d'aprés le preambule de la revendication 1.

Pour économiser des coûts de développement spécifiques à chaque configuration particulière, un but de l'invention est donc de définir une conception de dispositif de commande électrique rotatif qui puisse être employée dans ces différentes configurations, qui soit peu encombrante, et qui puisse être personnalisable par des adaptations simples sans remettre en cause la structure générale du dispositif.

### BREVE DESCRIPTION DE L'INVENTION

Conformément à l'invention, il est proposé un dispositif de commande électrique de commande électrique rotatif comprenant :
- une base formant axe de rotation d'un actionneur et comprenant un organe de fixation axiale selon l'axe de rotation de l'actionneur,
- un actionneur mobile en rotation autour de la base,
   la géométrie de la base et celle de l'actionneur étant adaptées pour permettre une rotation de l'actionneur autour de la base sans limitation de course, ledit actionneur comprenant un élément détectable par un capteur,
- un circuit imprimé comprenant un capteur adapté pour détecter un mouvement dudit élément et pour transformer ledit mouvement détecté en un signal électrique, ledit circuit imprimé étant solidaire de la base,
- un dispositif de rappel de l'actionneur vers une position dite neutre, agencé entre la base et l'actionneur.
et un dispositif d'indexation pour retenir l'actionneur dans au moins une position déterminée dite indexée par rapport à la base, ledit dispositif d'indexation comprenant un support d'indexation définissant ladite au moins une position indexée, ledit support d'indexation étant porté par l'actionneur, et une bille montée à l'encontre de la sollicitation d'un élément élastique monté sur la base.

De par cette architecture, le dispositif rotatif est modulable en fonction des applications visées, à la fois en termes de type d'actionnement, de position de montage, de typologie des signaux électriques de sortie.

Selon une forme d'exécution préférée, ledit dispositif comprend en outre un dispositif d'indexation pour retenir l'actionneur dans au moins une position déterminée dite indexée par rapport à la base.

De manière particulièrement avantageuse, ledit dispositif d'indexation comprend un support d'indexation définissant les différentes positions indexées, ledit support d'indexation étant porté par l'actionneur, et une bille montée à l'encontre de la sollicitation d'un élément élastique monté sur la base.

Ledit support d'indexation présente de préférence une forme de couronne ou de portion de couronne.

Selon un mode de réalisation, le capteur est un capteur à effet Hall.

Ledit élément détectable peut alors être un aimant.

De manière préférée, ledit aimant est surmoulé dans l'actionneur.

Par ailleurs, ledit aimant peut présenter une forme annulaire.

Selon un autre mode de réalisation, le capteur est un capteur résistif.

Dans ce cas, ledit élément détectable peut être un peigne conducteur solidaire de l'actionneur en contact avec ledit capteur résistif.

Selon un mode de réalisation, le dispositif de rappel est un ressort de compression.

De manière alternative, le dispositif de rappel est un ressort de torsion.

### BREVE DESCRIPTION DES DESSINS

D'autres caractéristiques et avantages de l'invention ressortiront de la description détaillée qui va suivre, en référence aux dessins annexés sur lesquels :
- la figure 1 est une vue isométrique en coupe partielle d'un dispositif de commande électrique rotatif selon un mode de réalisation de l'invention,
- la figure 2 est une vue en coupe du dispositif de la figure 1,
- la figure 3 est une vue isométrique d'un dispositif de commande électrique rotatif selon un mode de réalisation proposant un rappel de l'actionneur vers une position neutre dans les deux directions de rotation,
- la figure 4 est une vue isométrique en coupe partielle d'un dispositif rotatif comprenant un dispositif d'indexation,
- la figure 5 est une vue en coupe d'un dispositif rotatif comprenant un dispositif d'indexation,
- la figure 6 est une vue en coupe d'un dispositif rotatif comprenant un dispositif d'indexation,
- la figure 7 est une vue isométrique en coupe partielle d'un dispositif rotatif comprenant un dispositif d'indexation,
- la figure 8 est une vue isométrique en coupe partielle d'un dispositif acceptant une rotation de l'actionneur sur une amplitude de 360°, avec une indexation des positions à chaque intervalle de 30°,
- la figure 9 est une vue isométrique en coupe partielle d'un dispositif autorisant un débattement de l'actionneur de ± 30° par rapport à une position centrale neutre, dans lequel les positions extrêmes de l'actionneur sont indexées,
- la figure 10 est une vue isométrique d'un dispositif rotatif monté en position verticale dans un support,
- la figure 11 est une vue isométrique d'un dispositif rotatif monté en position horizontale sur un support,
- la figure 12 est une vue isométrique en coupe partielle du dispositif de la figure 11,
- la figure 13 est une vue isométrique en coupe partielle d'un dispositif rotatif dans lequel le capteur est un capteur résistif.

### DESCRIPTION DETAILLEE DE MODES DE REALISATION DE L'INVENTION

Sauf mention contraire, la description qui suit s'applique à tous les modes de réalisation du dispositif selon l'invention, et est illustrée, lorsque cela est précisé, par des modes de réalisation particuliers.

Des éléments identiques ou similaires sont représentés d'une figure à l'autre avec les mêmes signes de référence.

### Base et actionneur

Le dispositif comprend une base qui forme l'axe de rotation d'un actionneur 1 et qui est fixe, l'actionneur 1 appartenant à la partie mobile du dispositif.

L'actionneur 1 présente une forme générale de révolution autour de son axe de rotation X, avec une surface extérieure généralement cylindrique (pouvant néanmoins présenter des aspérités en fonction de la préhension souhaitée), par l'intermédiaire de laquelle un utilisateur peut faire pivoter l'actionneur pour actionner le dispositif.

L'actionneur 1 est évidé intérieurement pour y loger la base ainsi que les autres composants de l'interrupteur.

Dans les modes de réalisation illustrés ici, la base comprend un corps de dispositif 6 solidaire d'un couvercle de corps 3.

Le corps 6 est partiellement évidé et comprend un logement 60 pour un circuit imprimé 5 portant un capteur qui sera décrit en détail plus bas.

Une fois que ledit circuit imprimé 5 a été inséré dans le logement 60 du corps 6, celui-ci est refermé par le couvercle de corps 3.

La fixation du couvercle de corps 3 sur le corps 6 est par exemple réalisée par trois vis 4 placées à 120° les unes des autres.

Le couvercle de corps 3 a notamment pour fonction de maintenir axialement le circuit imprimé 5 dans son logement 60 du corps 6.

La base comprenant le corps 6 et le couvercle 3 est par ailleurs adaptée pour être assemblée sur un support du dispositif, par exemple un tableau de bord, une télécommande, etc.

Comme on le verra plus bas, l'assemblage de la base sur le support peut être réalisé soit en position horizontale soit en position verticale, par différents moyens.

A cet effet, le couvercle de corps 3 et le corps 6 présentent une géométrie générale de révolution autour de l'axe X et ne comportent pas de butées susceptibles d'entraver la rotation de l'actionneur 1, ce qui autorise une rotation de l'actionneur sans limitation de course, sur une amplitude angulaire de 360°, voire davantage

De même, la partie interne de l'actionneur 1 coopérant avec le corps 6 et le couvercle 3 présente une géométrie générale de révolution autour de l'axe X, ne comportant pas de butées susceptibles de limiter sa course en rotation autour du corps 6 et du couvercle 3.

Pour permettre les deux types de montage du dispositif, la base fixe de l'interrupteur, comprenant le corps 6 et le couvercle de corps 3, est destinée à être assemblée sur un support par tout moyen de fixation axial, c'est-à-dire s'étendant selon l'axe X de rotation de l'actionneur 1.

A cet effet, le couvercle de corps 3 comprend un organe de fixation agencé le long de son axe X de révolution, ce qui permet de fixer le dispositif soit en position horizontale soit en position verticale sans entraver la rotation de l'actionneur 1.

De manière particulièrement avantageuse, ledit organe de fixation comprend un alésage cylindrique axial 30 pouvant recevoir une tige filetée, par l'intermédiaire de laquelle il pourra être fixé à un support.

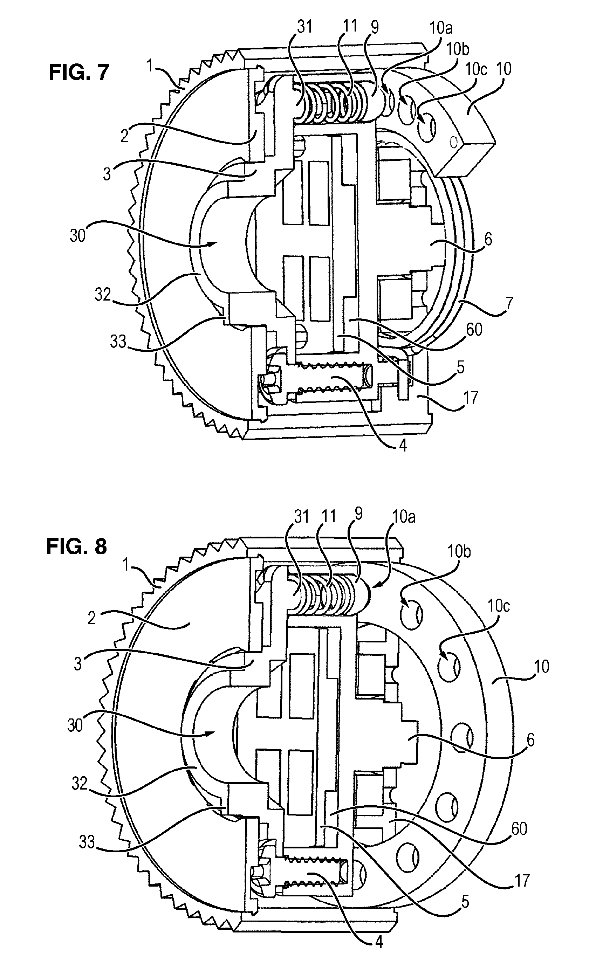

Par ailleurs, ledit organe de fixation peut comprendre un fût cylindrique axial 32 en saillie par rapport à la face correspondante de l'actionneur 1 et présentant un ergot 33 radial (visible par exemple aux figures 7 à 10).

Ledit fût 32 peut alors être inséré dans un orifice présentant une section de forme complémentaire agencé sur un support et y maintenir en place le dispositif, l'ergot 33 permettant d'éviter toute rotation de l'interrupteur par rapport au support.

Le corps 6 comprend quant à lui de préférence un ergot 61 en saillie par rapport à la face correspondante de l'actionneur 1.

Lorsque le dispositif est monté en position verticale, l'ergot 61 est inséré dans une face du support opposée à la face recevant le fût 32, de sorte que la base du dispositif est maintenue sur le support à ses deux extrémités.

De manière particulièrement avantageuse, ledit ergot 61 présente une forme qui n'est pas de révolution (par exemple triangulaire sur les figures annexées), de manière à empêcher toute rotation de la base par rapport au support.

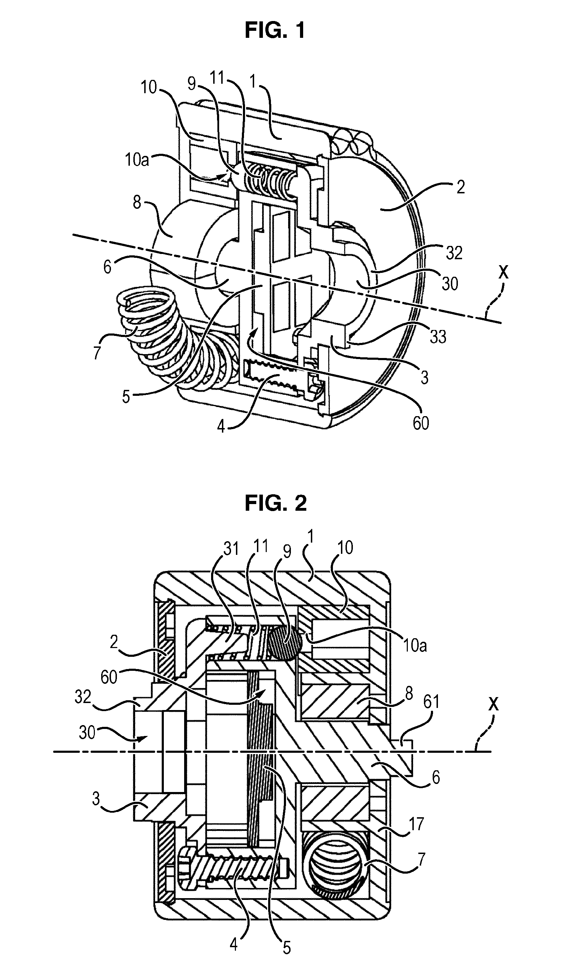

Comme on peut le voir à la figure 2, l'actionneur 1 présente, sur l'une de ses faces perpendiculaire à son axe X de rotation, une paroi 17 sensiblement plane percée d'un orifice central adapté pour laisser passer ledit ergot 61 du corps 6.

Eventuellement, si le dispositif est monté en position horizontale, ladite face 17 est visible par l'utilisateur et peut donc avantageusement être utilisée pour procurer à l'utilisateur des informations sur la position de l'actionneur.

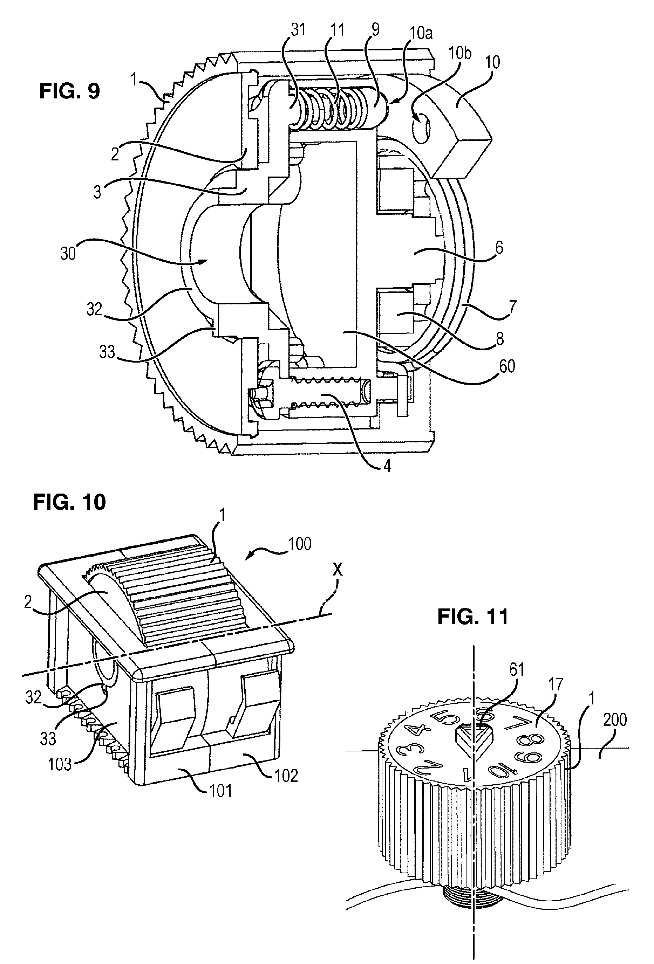

Par exemple, ladite face 17 peut supporter des marquages, comme cela est illustré à la figure 11.

Lesdits marquages peuvent par exemple être des chiffres correspondant à chacune des positions indexées de l'actionneur.

Du côté opposé à ladite face 17, l'actionneur 1 est fermé par un couvercle d'actionneur 2.

Ledit couvercle d'actionneur 2 se présente sous la forme générale d'un disque, percé en son centre d'un orifice pour laisser passer l'organe de fixation 30 du couvercle de corps 3.

Le couvercle d'actionneur 2 est fixé sur l'actionneur 1 après l'assemblage des différents composants du dispositif.

Par exemple, le mode de fixation du couvercle d'actionneur 2 sur l'actionneur 1 est un clippage.

Extérieurement, l'actionneur 1 présente une surface dite de préhension destinée à être manipulée par un utilisateur, généralement par l'extrémité d'un doigt.

La surface de préhension de l'actionneur présente donc de préférence un état de surface non glissant de manière à faciliter la manipulation.

Ainsi, la surface de préhension n'est pas lisse mais peut être, par exemple, striée.

Selon l'application du dispositif, la surface de préhension peut couvrir toute la surface externe de l'actionneur.

Par exemple, lorsque l'amplitude de débattement angulaire de l'actionneur est de 360°, toute la surface externe de l'actionneur peut être couverte de stries parallèles à l'axe de rotation, pour permettre une bonne préhension quelle que soit la position angulaire de l'actionneur.

De manière alternative, la surface de préhension peut n'occuper que la partie de la surface externe de l'actionneur qui est destinée à être effectivement manipulée par l'utilisateur.

Par exemple, si l'actionneur est destiné à se déplacer selon un angle maximal de 30° dans les deux directions, la surface de préhension peut être limitée à une surface correspondant à un débattement de 30° de part et d'autre d'une position centrale neutre, le reste de la surface externe pouvant être lisse.

Eventuellement, la surface de préhension peut être en relief par rapport au reste de la surface externe.

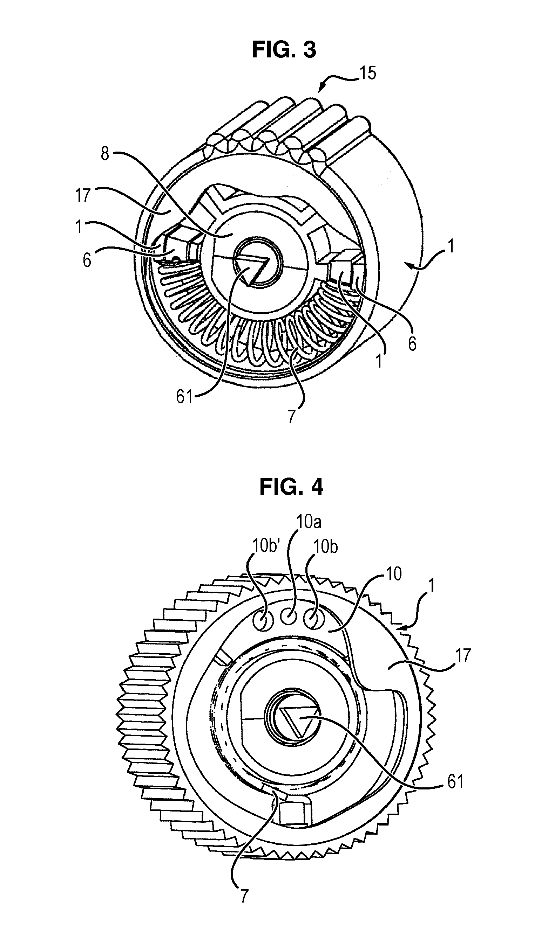

Ainsi, dans l'exemple illustré à la figure 3, la surface de préhension 15 se présente sous la forme d'une série d'excroissances arrondies s'étendant radialement à partir de la surface externe de l'actionneur 1, lesdites excroissances étant localisées au niveau de la position centrale neutre du dispositif et permettant une manipulation plus aisée avec l'extrémité d'un doigt.

Il va de soi que ces exemples ne sont donnés qu'à titre d'illustration et que l'on pourra définir tout autre état de surface et/ou forme appropriée selon l'ergonomie et l'esthétique que l'on souhaitera donner au dispositif.

### Capteur

Le dispositif comprend également un circuit imprimé 5 comportant un capteur, de manière à transformer un mouvement de l'actionneur en un signal déterminé.

Le circuit imprimé peut être programmé pour fournir différents types de signaux selon l'application envisagée.

On peut citer, parmi les signaux de sortie, les signaux analogiques, les signaux MLI (acronyme du terme modulation de largeur d'impulsion) ; le circuit imprimé peut également comprendre des sorties transistorisées à logique positive ou négative (NPN ou PNP), sur un ou deux canaux indépendants.

Différentes technologies de capteurs peuvent être employées, parmi lesquelles on citera les capteurs à effet Hall ou les capteurs résistifs.

Le circuit imprimé 5 comportant le capteur est solidaire du corps 6.

Par exemple, le circuit imprimé 5 est logé perpendiculairement à l'axe de révolution du corps 6, dans un logement 60 dont la forme est adaptée à celle du circuit imprimé 5, permettant de le maintenir radialement.

Le circuit imprimé 5 est maintenu axialement dans le logement 60 du corps 6 grâce au couvercle de corps 3.

L'actionneur 1 comprend pour sa part un élément 8 détectable par ledit capteur.

Si le capteur est un capteur à effet Hall, l'élément détectable 8 comprend de préférence un aimant.

La variation de flux magnétique provoquée par l'aimant est détectée par le capteur à effet Hall qui transforme ce mouvement en signaux électriques.

Selon un mode de réalisation avantageux de l'invention, l'actionneur comprend un aimant 8 de forme circulaire.

De manière préférée, l'actionneur est réalisé en un matériau thermoplastique. L'actionneur peut ainsi être avantageusement surmoulé sur l'aimant 8.

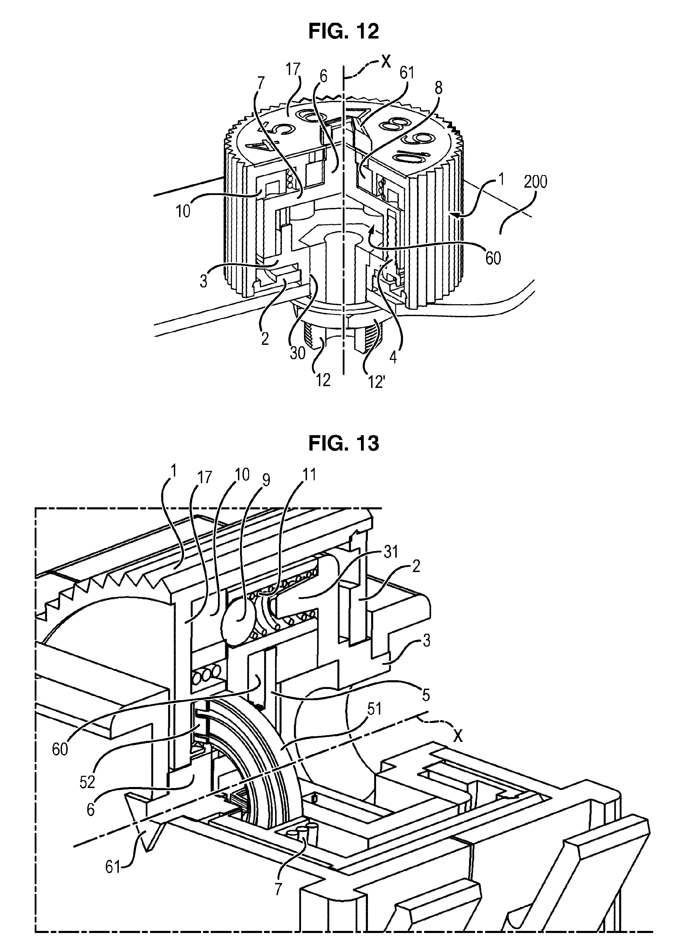

Si le capteur est un capteur résistif, comme cela est le cas à la figure 13, l'élément détectable comprend des peignes de contact 52 solidaires de l'actionneur 1.

Lesdits peignes de contact 52 sont agencés de sorte à être en contact avec un élément résistif 51 présentant une géométrie de révolution, porté par le circuit imprimé 5.

### Dispositif de rappel

Pour permettre le rappel de l'actionneur 1 vers une position neutre, le dispositif comprend un dispositif de rappel 7.

Ledit dispositif de rappel 7 consiste généralement en un élément élastique agencé entre le corps 6 et l'actionneur 1, qui est contraint de manière à procurer un effort de sortie de la position neutre déterminé, par exemple de l'ordre de 1,5 N dans chacune des directions d'actionnement.

Selon un premier mode de réalisation, visible aux figures 1, 2, 3 et 6, ledit élément élastique est un ressort de compression.

Ledit ressort 7 de compression est agencé dans un logement en forme d'arc de cercle de l'actionneur 1, entourant partiellement le corps 6.

Chaque extrémité du ressort est fixée au corps 6.

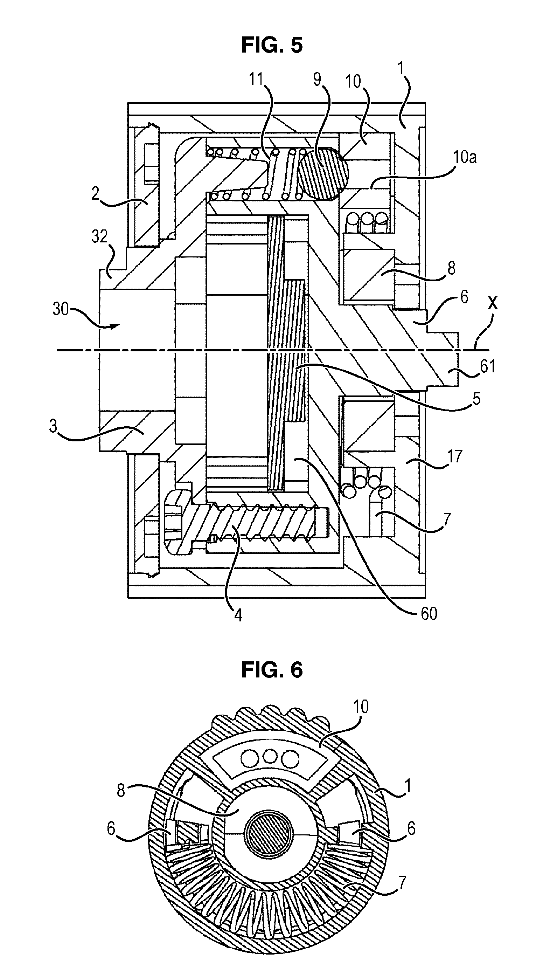

Selon un autre mode de réalisation, visible aux figures 4 et 5, ledit élément élastique est un ressort de torsion.

Ledit ressort 5 de torsion est agencé dans l'actionneur 1, autour du corps 6, chaque extrémité du ressort 5 étant fixée au corps 6.

### Dispositif d'indexation

Selon la fonction du dispositif rotatif, ledit dispositif peut comprendre un dispositif d'indexation, permettant de définir plusieurs positions de commutation, délivrant différents signaux de sortie.

Le dispositif d'indexation peut également permettre de limiter le débattement de l'actionneur sur une certaine course angulaire, par exemple de l'ordre de 30° de part et d'autre d'une position centrale neutre.

Le dispositif d'indexation comprend un élément d'indexation 9, par exemple une bille, montée sur la base (ici, sur le couvercle de corps 3) à l'encontre de la sollicitation d'un moyen élastique 11, tel qu'un ressort de compression.

A cet effet, le couvercle de corps 3 peut comprendre un pion 31 sur lequel est emmanché le ressort 11 pour le maintenir et le guider dans ses mouvements de compression et d'extension.

Le dispositif d'indexation comprend par ailleurs un support 10 en forme de portion de couronne (voire de couronne complète selon les applications) solidaire de l'actionneur 1 et comportant plusieurs logements 10a, 10b, 10b', etc. pour l'élément d'indexation 9, lesdits logements 10a, 10b, 10b' étant répartis angulairement sur la couronne selon les positions indexées souhaitées.

Dans les exemples illustrés ici, lesdits logements 10a, 10b, 10b' sont des évidements circulaires présentant un diamètre inférieur à celui de la bille 9.

Ainsi, lorsque l'on tourne l'actionneur 1, la bille 9 roule sur la surface du support 10 séparant deux logements puis, sous l'effet de la réaction du ressort 11, se loge dans un logement lorsqu'elle arrive sur celui-ci.

Dans l'exemple illustré à la figure 8, le support 10 a une forme de couronne et les logements 10a, 10b, 10c sont régulièrement répartis à des intervalles de 30°.

Dans l'exemple illustré à la figure 9, le support 10 est en forme d'une portion de couronne et ne comprend que trois logements situés respectivement à -30° et +30° de part et d'autre d'une position centrale neutre.

### Assemblage du dispositif rotatif

Les différents composants du dispositif rotatif peuvent être assemblés comme suit.

Le cas échéant, on rend l'actionneur 1 solidaire du support d'indexation 10.

On met en place le dispositif de rappel 7 dans l'actionneur 1.

Par ailleurs, on assemble la base fixe du dispositif en insérant le circuit imprimé 5 comportant le capteur dans le logement 60 du corps 6, puis l'on referme le corps 6 en vissant par l'intermédiaire des trois vis 4 le couvercle de corps 3 sur le corps 6.

Le cas échéant, on met en place le moyen élastique 11 du dispositif d'indexation sur le pion 31 du couvercle de corps 3.

On insère la base ainsi assemblée dans l'actionneur 1, de sorte que l'ergot 61 du corps 6 passe à travers l'orifice ménagé à cet effet dans la face 17.

Le cas échéant, on intercale la bille d'indexation 9 entre le support d'indexation 10 et le pion 31 du couvercle de corps 3.

Enfin, on referme l'actionneur 1 en clippant dans celui-ci le couvercle d'actionneur 2.

Les orifices ménagés dans la face 17 de l'actionneur 1 et dans le couvercle d'actionneur 2 permettent de centrer respectivement le corps 6 et le couvercle de corps 3 par rapport à l'actionneur 1.

Le dispositif rotatif est alors prêt à être monté sur un support tel qu'une télécommande, un tableau de bord, ou toute autre interface à partir de laquelle il est destiné à être actionné par un utilisateur.

### Montagne du dispositif rotatif sur un support

Selon un mode de réalisation illustré à la figure 10, le dispositif rotatif est monté en position verticale dans un boîtier 100.

Le support 100 comprend deux parties symétriques 101, 102 qui sont assemblées après que l'interrupteur a été mis en place entre elles.

A cet effet, l'une des parois latérales 103 de la partie 101 perpendiculaire à l'axe X de rotation présente un évidement complémentaire de la forme du fût 32 de l'organe de fixation.

Dans la mesure où le fût 32 présente un ergot radial 33, il est ainsi bloqué en rotation dans la paroi 103 du support.

Bien que cela ne soit pas visible sur la figure 10, l'ergot 61 du corps 6 est également inséré dans la paroi latérale de la partie 102 du support, parallèle à la paroi 103.

Ensuite, les deux parties 101 et 102 du support sont rapprochées et maintenues jointives par tout moyen approprié, tel que des clips, des vis, etc.

Selon un mode de réalisation illustré aux figures 11 et 12, le dispositif est monté en position horizontale sur un support 200.

A cet effet, une pièce filetée 12 a été insérée dans l'alésage 30 de l'organe de fixation du couvercle de corps 3, puis le dispositif a été mis en place sur le support 200 et un écrou 12' a été vissé sur la pièce filetée 12, emprisonnant ainsi la paroi du support 200.

Enfin, il va de soi que les exemples que l'on vient de donner ne sont que des illustrations particulières en aucun cas limitatives quant aux domaines d'application de l'invention.

Ainsi, le dispositif rotatif décrit ci-dessus peut être utilisé notamment, mais de manière non limitative, en tant que :
- commutateur rotatif à rappel au centre avec un débattement personnalisable grâce au dispositif d'indexation ;
- commutateur à bascule à une ou plusieurs positions indexées, dont le débattement est personnalisable, les signaux électriques de sortie étant personnalisables en fonction de l'angle de rotation ;
- encodeur rotatif sur une amplitude de 360°, avec ou sans friction, dont le nombre de points peuvent être personnalisés, les signaux électriques de sortie étant personnalisables en fonction de l'angle de rotation.

## Revendications

1. Dispositif de commande électrique rotatif comprenant :
- une base (6, 3) formant axe de rotation d'un actionneur (1) et comprenant un organe (30, 32) de fixation axiale selon l'axe (X) de rotation de l'actionneur (1),
- un actionneur (1) mobile en rotation autour de la base (6, 3), la géométrie de la base (6, 3) et celle de l'actionneur (1) étant adaptées pour permettre une rotation de l'actionneur (1) autour de la base (6, 3) sans limitation de course, ledit actionneur (1) comprenant un élément (8) détectable par un capteur,
- un circuit imprimé (5) comprenant un capteur adapté pour détecter un mouvement dudit élément (8) et pour transformer ledit mouvement détecté en un signal électrique, ledit circuit imprimé (5) étant solidaire de la base,
- un dispositif d'indexation pour reternir l'actionneur dans au moins une position déterminée dite indexée par rapport à la base,
**caractérisé en ce que** le dispositif comprend:
- un dispositif (7) de rappel de l'actionneur (1) vers une position dite neutre, agencé entre la base (6, 3) et l'actionneur (1), et
- et **en ce que** ledit dispositif d'indexation comprend un support (10) d'indexation définissant ladite au moins une position indexée, ledit support (10) d'indexation étant porté par l'actionneur (1), et une bille (9) montée à l'encontre de la sollicitation d'un élément élastique (11) monté sur la base (6, 3).

2. Dispositif selon la revendication 1, **caractérisé en ce que** ledit support (10) d'indexation présente une forme de couronne ou de portion de couronne.

3. Dispositif selon l'une des revendications 1 à 2, **caractérisé en ce que** le capteur est un capteur à effet Hall.

4. Dispositif selon la revendication 3, **caractérisé en ce que** ledit élément détectable (8) est un aimant.

5. Dispositif selon la revendication 4, **caractérisé en ce que** ledit aimant est surmoulé dans l'actionneur (1).

6. Dispositif selon l'une des revendications 4 ou 5, **caractérisé en ce que** ledit aimant présente une forme annulaire.

7. Dispositif selon l'une des revendications 1 à 2, **caractérisé en ce que** le capteur est un capteur résistif.

8. Dispositif selon la revendication 7, **caractérisé en ce que** ledit élément détectable est un peigne conducteur solidaire de l'actionneur (1) en contact avec ledit capteur résistif.

9. Dispositif selon l'une des revendications 1 à 8, **caractérisé en ce que** le dispositif (7) de rappel est un ressort de compression.

10. Dispositif selon l'une des revendications 1 à 8, **caractérisé en ce que** le dispositif de rappel (7) est un ressort de torsion.

## Patentansprüche

1. Rotierende elektrische Vorrichtung, umfassend:
- eine Basis (6, 3), die eine Rotationsachse eines Betätigungsgliedes (1) bildet und ein axiales Befestigungsorgan (30, 32) gemäß der Rotationsachse (X) des Betätigungsgliedes (1) bildet,
- ein in Rotation um die Basis (6, 3) mobiles Betätigungsglied (1),
wobei die Geometrie der Basis (6, 3) und die des Betätigungsgliedes (1) geeignet sind, um eine Rotation des Betätigungsgliedes (1) um die Basis (6, 3) ohne Begrenzung des Laufs zu erlauben, wobei das genannte Betätigungsglied (1) ein durch einen Sensor erfassbares Element (8) umfasst,
- eine bedruckte Leiterplatte (5), umfassend einen Sensor, der geeignet ist, um eine Bewegung des genannten Elements (8) zu erfassen und um die genannte erfasste Bewegung in ein elektrisches Signal umzuwandeln, wobei die genannte bedruckte Leiterplatte (5) mit der Basis fest verbunden ist,
- eine Indexierungsvorrichtung zum Zurückhalten des Betätigungsgliedes in wenigstens einer bestimmten, so genannten im Verhältnis zur Basis indexierten Position,
**dadurch gekennzeichnet, dass** die Vorrichtung umfasst:
- eine Rückholvorrichtung (7) des Betätigungsgliedes (1) in eine so genannte neutrale Position, das zwisehen der Basis (6, 3) und dem Betätigungsglied (1) angeordnet ist, und
- dadurch, dass
die genannte Indexierungsvorrichtung einen Indexierungsträger (10) umfasst, der die genannte wenigstens eine indexierte Position definiert, wobei der genannte Indexierungsträger (10) durch das Betätigungsglied (1) getragen wird, und eine Kugel (9), die gegen das Ansprechen eines auf der Basis (6, 3) montierten elastischen Elements (11) montiert ist.

2. Vorrichtung gemäß Anspruch 1, **dadurch gekennzeichnet, dass** der genannte Indexierungsträger (10) eine Kronenform oder einen Kronenabschnitt aufweist.

3. Vorrichtung gemäß Anspruch 1 bis 2, **dadurch gekennzeichnet, dass** der Sensor ein Sensor mit Hallwirkung ist.

4. Vorrichtung gemäß Anspruch 3, **dadurch gekennzeichnet, dass** das genannte erfassbare Element (8) ein Magnet ist.

5. Vorrichtung gemäß Anspruch 4, **dadurch gekennzeichnet, dass** der genannte Magnet in einem Betätigungsglied (1) abgeformt ist.

6. Vorrichtung gemäß Anspruch 4 oder 5, **dadurch gekennzeichnet, dass** der genannte Magnet eine ringförmige Form aufweist.

7. Vorrichtung gemäß Anspruch 1 bis 2, **dadurch gekennzeichnet, dass** der Sensor ein Widerstandssensor ist.

8. Vorrichtung gemäß Anspruch 7, **dadurch gekennzeichnet, dass** das genannte erfassbare Element ein leitender Kamm ist, der fest mit dem Betätigungsglied (1) verbunden ist, das mit dem genannten Widerstandssensor in Kontakt ist.

9. Vorrichtung gemäß Anspruch 1 bis 8, **dadurch gekennzeichnet, dass** die genannte Rückholvorrichtung (7) eine Druckfeder ist.

10. Vorrichtung gemäß Anspruch 1 bis 8, **dadurch gekennzeichnet, dass** die Rückholvorrichtung (7) eine Drehfeder ist.

## Claims

1. Rotary electric control device comprising:
- a base (6, 3) forming a rotation axis of an actuator (1) and comprising a member (30, 32) for axial fixation along the axis (X) of rotation of the actuator (1),
- an actuator (1) that can move in rotation around the base (6, 3),
the geometry of the base (6, 3) and that of the actuator (1) being adapted to permit rotation of the actuator (1) around the base (6, 3) without travel path limitation, said actuator (1) comprising an element (8) that can be detected by a sensor,
- a printed circuit (5) comprising a sensor adapted to detect a movement of said element (8) and for transforming said detected movement into an electrical signal, said printed circuit (5) being fixed to the base (6, 3),
- an indexing device for retaining the actuator in at least one so-called indexed predetermined position with respect to the base,
**characterised in that** the device comprises:
- a device (7) for returning the actuator (1) to a so-called neutral position, arranged between the base (6, 3) and the actuator (1), and
- and **in that**
said indexing device comprises a support (10) for indexing defining said at least one index position, said support (10) for indexing being carried by the actuator (1), and a ball (9) mounted against the urging of an elastic element (11) mounted on the base (6, 3).

2. Device according to claim 1, **characterized in that** said support (10) for indexing has the shape of a ring or portion of a ring.

3. Device according to one of claims 1 to 2, **characterised in that** the sensor is a Hall effect sensor.

4. Device according to claim 3, **characterised in that** said detectable element (8) is a magnet.

5. Device according to claim 4, **characterised in that** said magnet is overmoulded in the actuator (1).

6. Device according to one of claims 4 or 5, **characterised in that** said magnet has an annular shape.

7. Device according to one of claims 1 to 2, **characterised in that** the sensor is a resistive sensor.

8. Device according to claim 7, **characterised in that** said detectable element is a comb driver integral with the actuator (1) in contact with said resistive sensor.

9. Device according to one of claims 1 to 8, **characterised in that** the device (7) for returning is a compression spring.

10. Device according to one of claims 1 to 8, **characterised in that** the return device (7) is a torsion spring.
